# EUROPEAN PATENT APPLICATION

(11) **EP 0 911 611 A1**
(43) Date of publication of application: **28.04.1999**
(21) Application number: 98300710.5
(22) Date of filing: 30.01.1998
(51) Int. Cl.: G01D 5/249, G01D 5/347, G01B 7/30, H03M 1/00

(54) **Rotary encoder**

(30) Priority: 21.10.1997 KR 9754009
(71) Applicant: Samsung Electronics Co., Ltd., Suwon-City, Kyungi-do (KR)
(72) Inventor: Choe, You-young, Paldal-gu, Suwon-city, Kyungki-do (KR)
(74) Representative: Geary, Stuart Lloyd

(57) **Abstract**

Disclosed is a rotary encoder having a high resolution. The rotary encoder according to the present invention comprises a rotary disc, first code patterns which are formed at predetermined positions of the rotary disc and used for detecting a reference position of the rotary disc, second code patterns which are concentriacally formed on the rotary disc in a plurality row and used for detecting a displacement of the rotary disc, wherein numbers of patterns formed in each row of the second patterns have a relationship of having only single common divisior i.e. one, a first sensor which is disposed to correspond to the first patterns, for detecting the reference position of the rotary disc, and second sensors which are respectively disposed to correspond to each pattern row of the second code patterns, for detecting the displacement of the rotary disc. According to the present invention, the rotary encoder is capable of having the high resolution in spite of having a few of slits.

## Description

The present invention relates to a rotor for a rotary encoder having a sensible pattern comprising a plurality of concentric rings of pattern elements.

Rotary encoders are used in connection with motors in domestic appliances, industrial machinery, and the like, in order to control the speed or the angle of rotation of motors. Rotary encoders come in three types, i.e. optical, contact-type, and magnetic rotary encoders. Rotary encoders also differ in the code patterns used on their discs and the methods of reading the code patterns.

US-A-4833316, US-A-4654525 and US-A4152589 disclose optical rotary encoders. KR-U-94-10707 and KR-A-92-9050 disclose contact-type rotary encoders. KR-A-93-11887 and US-A-4732494 disclose magnetic rotary encoders.

The resolution of such a rotary encoder is generally determined by the number of pattern elements which are formed in each ring on its disc. For example, an optical rotary encoder may have a plurality of slits is formed on a disc such that the optical rotary encoder has a resolution of 0.7°.

A highly precise machining technology is required to form hundreds of slits in a ring, and the manufacturing cost of the optical rotary encoder is therefore high. Further, in the case that the radius of the rotary disc is increased to lower the machining accuracy of the slits, the size of the rotary encoder is also increased.

The KR-U-93-15280 discloses a rotary encoder in which slits are formed in a disc in two rings to reduce the number of slits, thus improving the resolution of the rotary encoder. However, the rotary encoder has a disadvantage in that slits should be formed in a ring on the disc in order that the rotary encoder has a resolution of 0.7°.

A rotor according to the present invention is characterised in that the numbers of pattern elements in said rings have 1 as their only common divisor. The rotor will usually be a disc. However, it may take other forms, for example a cylinder.

Preferably, the pattern elements comprise apertures, electrically conductive regions or magnetic regions.

Preferably, at a reference position, radial edges of pattern elements from each row are aligned.

Embodiments of the present invention will now be described, by way of example, with reference to the accompanying drawings, in which:-
Figure 1 is a perspective view of a first embodiment of a rotary encoder according to the present invention;
Figure 2 is a perspective view of a second embodiment of a rotary encoder according to the present invention; and
Figure 3 is a perspective view of a third embodiment of a rotary encoder according to the present invention.

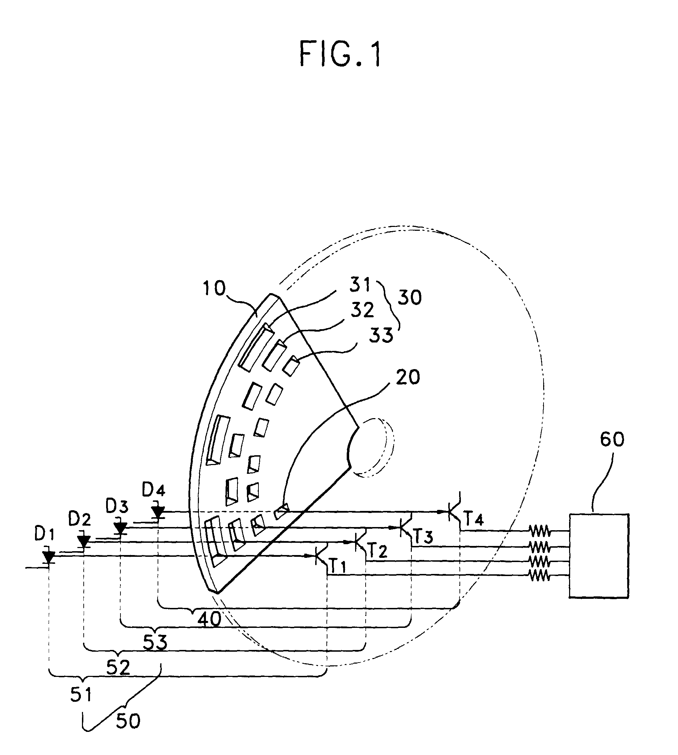

Referring to Figure 1, a rotary encoder comprises a rotary disc 10, a first code pattern 20, a second code pattern 30, a first sensor 40, a plurality of second sensors 50, and a control circuit section 60.

The rotary disc 10 is coupled to a shaft of a motor (not shown). The first code pattern 20 is formed at predetermined positions. The second code pattern 30 is formed on the rotary disc 10 in such a manner that the second code pattern 30 is between the rim of the rotary disc 10 and the first code pattern 20.

The second code pattern 30 comprises a plurality of rings 31, 32, 33 which are concentrically formed in rotary disc 10 and have respectively different radiuses to each other. Each ring 31, 32 and 33 of the second pattern 30 comprises a plurality of apertures in the rotary disc 10. The number of slits (L, M, and N) in each ring 31, 32, 33 have relationship of having only a single common divisor, i.e. one.

If all natural numbers in the range 1 to LMN are divided by L, M and N, different combinations of remainder values are obtained. For example, if L is 2, M is 3 and N is 5, LMN = 30, the remainders shown in Table 1 are obtained.

**Table 1**

| | **L=2** | **M=3** | **N=5** |
|---|---|---|---|
| 1 | 1 | 1 | 1 |
| 2 | 0 | 2 | 2 |
| 3 | 1 | 0 | 3 |
| 4 | 0 | 1 | 4 |
| 5 | 1 | 2 | 0 |
| 6 | 0 | 0 | 1 |
| 7 | 1 | 1 | 2 |
| 8 | 0 | 2 | 3 |
| 9 | 1 | 0 | 4 |
| 10 | 0 | 1 | 0 |
| 11 | 1 | 2 | 1 |
| 12 | 0 | 0 | 2 |
| 13 | 1 | 1 | 3 |
| 14 | 0 | 2 | 4 |
| 15 | 1 | 0 | 0 |
| 16 | 0 | 1 | 1 |
| 17 | 1 | 2 | 2 |
| 18 | 0 | 0 | 3 |
| 19 | 1 | 1 | 4 |
| 20 | 0 | 2 | 0 |
| 21 | 1 | 0 | 1 |
| 22 | 0 | 1 | 2 |
| 23 | 1 | 2 | 3 |
| 24 | 0 | 0 | 4 |
| 25 | 1 | 1 | 0 |
| 26 | 0 | 2 | 1 |
| 27 | 1 | 0 | 2 |
| 28 | 0 | 1 | 3 |
| 29 | 1 | 2 | 4 |
| 30 | 0 | 0 | 0 |

When the numbers L, M, and N of the patterns are respectively 10, 11 and 13, the rotary encoder has a resolution of 0.25°. Accordingly, even though the number of the apertures is reduced, the rotary encoder has a high resolution.

A first sensor 40 is disposed to correspond to the first code pattern 20 and a plurality of second sensors 50 is disposed so that each sensor corresponds to a respective ring 31, 32, 33 of second code pattern 30.

The first and second sensors 40, 50 comprise a opto-coupler or pairs of light beam emitting and receiving elements, including light beam emitting elements such as photodiodes D1, D2, D3, D4 which are disposed to face one side of the rotary disc 10 and light beam receiving elements such as photo transistors T1, T2, T3, T4.

A fixed plate (not shown) having a slit is disposed between the rotary disc 10 and pairs of light beam emitting and receiving elements 40, 51, 52, 53 so that the light beams can pass through the slit of the fixed plate. Control circuit section 60 filters output signals from light beam receiving elements T, T2, T3, T4 so as to produce pulse signals.

The control circuit section 60 produces address signals by combing the values of pulse signals from the second code pattern 30. The control circuit section 60 reads angles from the addresses of a ROM, in which a lockup table, formed on the basis of address signals and Table 1, is stored so as to output the angles stored at the addresses.

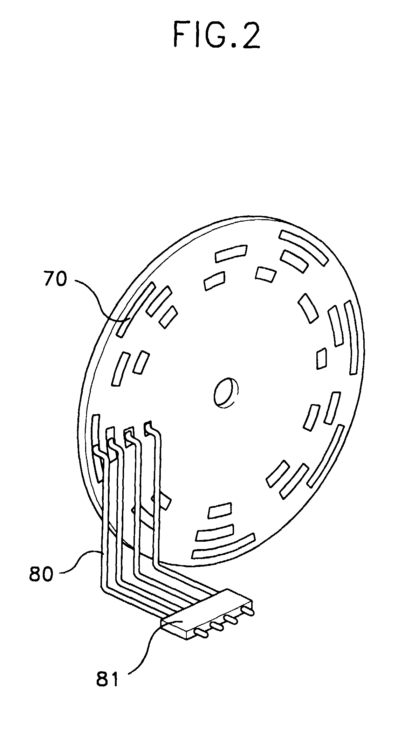

Referring to Figure 2, the code patterns of the rotary encoder are formed with electric conductors 70 which are printed on the rotary disc. A predetermined voltage, for example an earth voltage is applied to electric conductors 70. Sensors 81 make contact with electric conductors 70 in such a manner that connector 80 comes into slidably contact with surfaces of electric conductors 70.

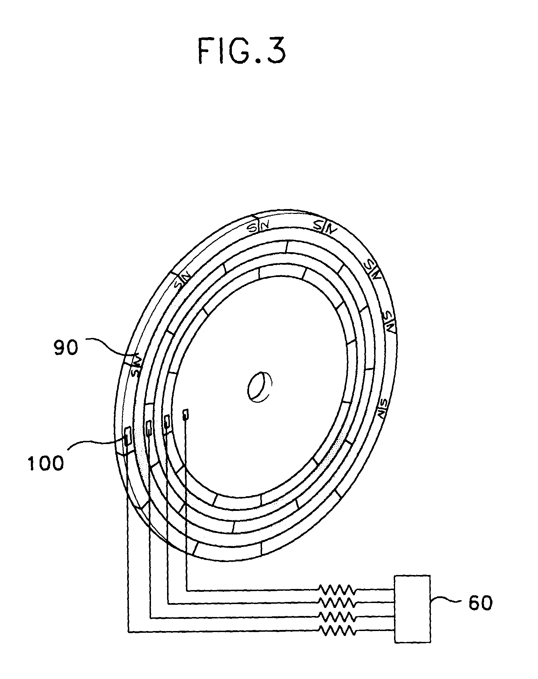

Referring to Figure 3, the code patterns of the rotary encoder are constituted of pairs of magnetic poles. Flux detectors such as hall elements 100 are used as sensors, which are closely disposed at pairs of magnetic poles 90.

As described above, the rotary encoder according to the present invention is capable of having a high resolution in spite of reducing a lot of code patterns which re formed on the rotary disc and used for detecting angles. As a result, a manufacturing cost of the rotary encoder can be reduced as well as the rotary encoder can be made compact size.

## Claims

1. A rotor for a rotary encoder having a sensible pattern (30) comprising a plurality of concentric rings (31, 32, 33) of pattern elements, **characterised in that** the numbers of pattern elements in said rings (31, 32, 33) have 1 as their only common divisor.

2. A rotor according to claim 1, wherein the pattern elements comprise apertures.

3. A rotor according to claim 1, wherein the pattern elements comprise electrically conductive regions.

4. A rotor according to claim 1, wherein the pattern elements comprise magnetic region.

5. A rotary encoder comprising:
a rotary disc;
first code patterns which are formed at predetermined positions of the rotary disc and used for detecting a reference position of the rotary disc;
second code patterns which are concentrically formed on the rotary disc in a plurality row and used for detecting a displacement of the rotary disc, a numbers of patterns which are formed in each row of the second patterns having a relationship of having only single common divisior i.e. one.
a first sensor which is disposed to correspond to the first patterns, for detecting the reference position of the rotary disc; and
second sensors which are respectively disposed to correspond to each pattern row of the second code patterns, for detecting the displacement of the rotary disc.

6. The rotary encoder as claimed in claim 5, wherein the first and second code patterns include at least one slit formed on the rotary disc.

7. The rotary encoder as claimed in claim 6, wherein the first and second sensors respectively comprise light beam emitting elements which are disposed to correspond to one surface of the rotary disc for emitting light beams, and light beam receiving elements disposed to correspond to another surface of the rotary disc for receiving the light beans emitted from the light beam emitting elements.

8. The rotary encoder as claimed in claim 5 wherein the first and second code patterns comprise electric conductor and a predetermined electric voltage is applied to the electric conductors.

9. The rotary encoder as claimed in claim 8, wherein the first and second sensors include connectors being slidably contact with the electric conductors of the first and second code patterns.

10. The rotary encoder as claimed in claim 5, wherein the first and second code patterns have pairs of magnetic poles.

11. The rotary encoder as claimed in claim 10, wherein the first and second sensors comprise magnetic flux detecting sensors being closely disposed at each row of the first and second code patterns having pairs of magnetic poles.

12. The rotary encoder as claimed in claim 11, wherein the magnetic flux detecting sensors comprise hall elements.

13. A rotary encoder comprising:
a rotary disc;
first slits which are formed at predetermined positions of the rotary disc and used for detecting a reference position of the rotary disc;
second slits which are concentrically formed on the rotary disc in three rows, for detecting the displacement of the rotary disc, and numbers of patterns which are formed in each row of the second patterns having a relationship of having only single common divisor i.e. one;
a pair of first light beam detecting sensors which are disposed to correspond to the first slit patterns, for detecting the reference position of the rotary disc;
at least three pairs of second light beam detecting sensors which are respectively disposed to correspond to each slit row, for detecting the displacement of the rotary disc;

14. A rotary encoder comprising:
a rotary disc;
first slits formed at predetermined positions of the rotary disc and used for detecting a reference position of the rotary disc;
second slits formed concentrically formed on the rotary disc in three rows, for detecting the displacement of the rotary disc, and numbers of patterns which are formed in each row of the second patterns having a relationship of having only single common divisor i.e. one;
a pair of first light beam detecting sensors which are disposed to correspond to the first slit patterns, for detecting the reference position of the rotary disc;
at least three pairs of second light beam detecting sensors which are respectively disposed to correspond to each slit row, for detecting the displacement of the rotary disc; and
a control circuit section for calculating a rotation angel of the rotary disc in such a manner of responding to output signals from the first light beam detecting sensors, counting respective output signals from the pairs of second light beam detecting sensors, and combing counted values of the respective output signals from the pairs of second light beam detecting sensors.
